# EUROPEAN PATENT SPECIFICATION

(11) **EP 2 077 256 B1**
(45) Date of publication and mention of the grant of the patent: **04.09.2013**
(21) Application number: 07830691.7
(22) Date of filing: 26.10.2007
(51) Int. Cl.: C04B 35/46, H01C 7/02

(54) **SEMICONDUCTOR CERAMIC COMPOSITION AND METHOD FOR PRODUCING THE SAME**
HALBLEITERKERAMIKZUSAMMENSETZUNG UND HERSTELLUNGSVERFAHREN DAFÜR
COMPOSITION CÉRAMIQUE DE SEMI-CONDUCTEUR ET SON PROCÉDÉ DE FABRICATION

(30) Priority: 27.10.2006 JP 2006292471
(43) Date of publication of application: 08.07.2009
(73) Proprietor: Hitachi Metals, Ltd., Minato-ku Tokyo 105-8614 (JP)
(72) Inventor: SHIMADA, Takeshi, Saitama 360-0843 (JP); TOJI, Kazuya, Osaka 618-0013 (JP)
(74) Representative: Zimmermann & Partner
(86) International application number: PCT/JP2007/070957
(87) International publication number: WO 2008/050875

(56) References cited:
- WO-A-2006/106910
- WO-A1-2006/106910
- WO-A1-2007/097462
- JP-A- 2006 179 692
- JP-A- 2006 179 692
- TADASHI TAKENAKA ET AL: "(BI1/2NA1/2)TIO3-BATIO3 SYSTEM FOR LEAD-FREE PIEZOELECTRIC CERAMICS", JAPANESE JOURNAL OF APPLIED PHYSICS, JAPAN SOCIETY OF APPLIED PHYSICS, JP, vol. 30, no. 9B, 1 September 1991 (1991-09-01), pages 2236-2239, XP000269862, ISSN: 0021-4922, DOI: DOI:10.1143/JJAP.30.2236
- TADASHI SHIOSAKI ET AL: "Development of Lead-Free PTC Thermistor Materials", APPLICATIONS OF FERROELECTRICS, 2006. ISAF '06. IEEE INTERNATIONA L SYMPOSIUM ON THE, IEEE, PI, 1 July 2006 (2006-07-01), pages 193-196, XP031164223, ISBN: 978-1-4244-1331-7
- HUO W ET AL: "Effects of Bi1/2Na1/2TiO3 on the Curie temperature and the PTC effects of BaTiO3-based positive temperature coefficient ceramics", SENSORS AND ACTUATORS A, ELSEVIER SEQUOIA S.A., LAUSANNE, CH, vol. 128, no. 2, 19 April 2006 (2006-04-19), pages 265-269, XP025081734, ISSN: 0924-4247, DOI: DOI:10.1016/J.SNA.2006.01.022 [retrieved on 2006-04-19]
- WEIRONG HUO ET AL.: 'Effects of Bi1/2Na1/2TiO3 on the Curie temperature and the PTC effects of BaTiO3-based positive temperature coefficient ceramics' SENSORS AND ACTUATORS A vol. 128, 20 February 2006, pages 265 - 269, XP005367212

## Description

### TECHNICAL FIELD

The present invention relates to method for producing a semiconductor ceramic composition having a positive resistive temperature, which is used for a PTC thermistor, a PTC heater, a PTC switch, a temperature detector and the like.

### BACKGROUND ART

As materials showing a PTCR characteristic (Positive Temperature Coefficient of Resistivity), compositions in which various semiconductive dopants are added to BaTiO₃ have been conventionally proposed (see, Patent Document 1). These compositions have a Curie temperature around 120°C. Depending upon the use, it becomes necessary for these compositions to shift Curie temperature.

It has been proposed to shift the Curie temperature by adding, for example, SrTiO₃ to BaTiO₃ containing Sb₂O₃ and Nb₂O₃ (see, Patent Document 2). However, the Curie temperature shifts only in a negative direction and does not shift in a positive direction in this case. Currently, only PbTiO₃ is known as an addition element for shifting the Curie temperature in a positive direction (see, Patent Document 3). However, since PbTiO₃ contains an element that causes environmental pollution, a material using no PbTiO₃ has been demanded in recent years.

In the BaTiO₃ semiconductor ceramic, there is proposed a method for producing a BaTiO₃ semiconductor ceramic by adding one or more of Nb, Ta and rare earth elements to a composition having a structure of Ba₁₋₂ₓ(BiNa)ₓTiO₃, wherein a part of Ba in BaTiO₃ in which no PbTiO₃ is used is substituted with Bi-Na and x is controlled to be in a range of 0 < x ≤ 0.15, sintering the composition in nitrogen, and then subjecting the composition to a heat treatment in an oxidizing atmosphere (see, Patent Document 4).

In the case where the atomic valence of the composition is controlled in the system in which a part of Ba is substituted with Bi-Na, there arise problems when a trivalent cation is added as a semiconductive dopant such that the effect of semiconduction is reduced due to the presence of a monovalent Na ion and resistivity at room temperature increases. There is disclosed in Patent Document 4 as an example a composition obtained by adding 0.1 mol% of Nd₂O₃ as a semiconductive dopant to Ba₁₋₂ₓ(BiNa)ₓTiO₃ (0 < x ≤ 0.15), but this is not the amount capable of realizing sufficient semiconduction for PTC application.

For the purpose of solving the conventional problems of BaTiO₃ semiconductor ceramic composition, the present inventors have proposed a semiconductor ceramic composition represented by a formula [(Al_{0.5}A2_{0.5})ₓ(Ba_{1-y}Q_{y})]TiO₃ (wherein A1 is one or two or more of Na, K and Li, A2 is Bi, and Q is one or two or more of La, Dy, Eu and Gd), in which x and y each satisfy 0 < x ≤ 0.2, 0.002 ≤ y ≤ 0.01 (see, Patent Document 5), as a semiconductor ceramic composition capable of shifting a Curie temperature in the positive direction as well as largely reducing resistivity at room temperature without using Pb.
Patent Document 1: JP-B-51-41440
Patent Document 2: JP-B-8-22773
Patent Document 3: JP-B-62-58642
Patent Document 4: JP-A-56-169301
Patent Document 5: JP-A-2005-255493

From JP 2006 179692 A a method for manufacturing a thermistor which comprises a barium titanate based semiconductor material is known. The method comprises the steps of: (a) mixing a material containing barium, titanium and oxygen, or a material containing barium and oxygen, and a material containing titanium and oxygen as main materials; and at least one material containing an oxide including at least monovalent alkaline metal and titanium chemically bonded as an auxiliary material, with a stock material to serve as a dopant; (b) mixing a binder with the material mixed in step (a) for molding; and (c) producing the barium titanate based semiconductor by baking the molded material.

### DISCLOSURE OF THE INVENTION

### Problem that the Invention Is to Solve

Although the above-mentioned conventional compositions contain a rare earth element such as La or a tetravalent element such as Sb and Nb as a semiconductive dopant, the addition of such a semiconductive dopant, in particular, the trivalent rare earth element, results in admixture of the rare earth elements in Bi (trivalent) site at the time of calcination or sintering in the composition containing no Pb in which a part of Ba is substituted with Bi-Na, whereby control of atomic valence becomes difficult and, at the same time, causes dispersion of carrier concentration, i.e., electrical resistance.

Further, the above-mentioned conventional compositions are those manufactured by mixing the starting materials of all the elements constituting the compositions before calcination, followed by calcining, forming, sintering, and heat treatment. In particular, in the composition containing no Pb in which a part of Ba is substituted with Bi-Na disclosed in Patent Documents 4 and 5, Bi volatilizes during the calcining step and compositional deviation occurs in Bi-Na, whereby the formation of different phases is accelerated, and increase in resistivity at room temperature and fluctuation of Curie temperature are caused.

It may be considered to perform calcination at a low temperature for restraining the volatilization of Bi. However, although volatilization of Bi is certainly restrained by this method, a complete solid solution cannot be formed and desired characteristics cannot be obtained.

An object of the invention is to provide method for forming a semiconductor ceramic composition containing no Pb, which is capable of shifting the Curie temperate to a positive direction and of widely reducing resistivity at room temperature.

Further, it is another object of the invention to provide method for forming a semiconductor ceramic composition in which a part of Ba in BaTiO₃ is substituted with Bi-Na, which is not accompanied by entering of a trivalent rare earth element as a semiconductive dopant into Bi (trivalent) site at the time of calcination and sintering, is capable of easily controlling atomic valence, and is capable of restraining dispersion of electrical resistance.

Still another object of the invention is to provide method for forming a semiconductor ceramic composition in which a part of Ba in BaTiO₃ is substituted with Bi-Na, which is capable of restraining the volatilization of Bi in the calcining step, is capable of preventing the compositional deviation of Bi-Na thereby suppressing formation of different phases, is capable of further reducing resistivity at room temperature, and is capable of restraining fluctuation of Curie temperature.

### Means for Solving the Problem

As a result of intensive studies for attaining the above objects, the inventors have found that, in producing a semiconductor ceramic composition in which a part of Ba in BaTiO₃ is substituted with Bi-Na, when sintering is performed in an inert gas atmosphere having a low oxygen concentration, Ti³⁺ is formed in a solid solution by the reaction of Ti⁴⁺ + e → Ti³⁺ even if a semiconductive dopant such as a rare earth element is not added, whereby a semiconductor can be formed, and problems such as difficulty of control of atomic valence and dispersion of electrical resistance resulting from the mixture of semiconductive dopants in Bi (trivalent) site are solved.

Further, the present inventors have found that, in producing a semiconductor ceramic composition in which a part of Ba in BaTiO₃ is substituted with Bi-Na without using semiconductive dopant, by separately preparing a BaTiO₃ composition and a (BiNa)TiO₃ composition and calcining respective compositions at optimal temperatures of the BaTiO₃ composition at a relatively high temperature and the (BiNa)TiO₃ composition at a relatively low temperature (hereinafter referred to as "a separate calcination method"), the volatilization of Bi of the (BiNa)TiO₃ composition is restrained, and the compositional deviation of Bi-Na can be prevented and the formation of different phases can be suppressed, and by mixing, forming and sintering these calcined powders, a semiconductor ceramic composition low in resistivity at room temperature and controlled in fluctuation of Curie temperature can be obtained.

Still further, the present inventors have found that, in a case where the starting materials of all the elements constituting a composition are mixed at a time before calcination, Bi becomes a liquid phase at a calcination stage and forms a complicated intergranular structure, so that a single intergranular level is difficult to be formed and dispersion occurs in temperature coefficient of resistivity (a jump characteristic), and further, in forming a semiconductor by the reaction of Ti⁴⁺ + e → Ti³⁺ without adding a semiconductive dopant according to the above-mentioned knowledge, Ti³⁺ is consumed in the supplement of volatilized Bi and the effect of Ti⁴⁺ + e → Ti³⁺ is weakened and room temperature resistance heightens, so that it becomes necessary to add an element of controlling atomic valence. However, these problems are swept away by adopting the above-mentioned separate calcination method.

The invention provides a production method of a semiconductor ceramic composition in which a part of Ba of BaTiO₃ is substituted with Bi-Na, the method comprising a step of preparing a calcined powder of BaTiO₃, a step of preparing a calcined powder of (BiNa)TiO₃, a step of mixing the calcined powder of BaTiO₃ and the calcined powder of (BiNa)TiO₃, and a step of forming and sintering said mixed calcined powder.

Furthermore, according to the present invention the sintering step is carried out in an inert gas atmosphere having an oxygen concentration of 1% or less. Moreover, the semiconductor ceramic composition is represented by a composition formula [(BiNa)ₓBa₁₋ₓ]TiO₃ in which x satisfies 0 < x ≤ 0.3.

The invention further provides, in the production method of the above-mentioned structure:
a structure in which a calcining temperature in the step of preparing the calcined powder of BaTiO₃ is from 700 to 1,200°C;
a structure in which a calcining temperature in the step of preparing the calcined powder of (BiNa)TiO₃ is from 700 to 950°C;
a structure in which in the step of preparing the calcined powder of BaTiO₃, in the step of preparing the calcined powder of (BiNa)TiO₃, or in both of the steps, 3.0 mol% or less of Si oxide, and 4.0 mol% or less of Ca carbonate or Ca oxide are added before the calcination;
a structure in which in the step of mixing the calcined powder of BaTiO₃ and the calcined powder of (BiNa)TiO₃, 3.0 mol% or less of Si oxide, and 4.0 mol% or less of Ca carbonate or Ca oxide are added.

The result of the inventive process is a semiconductor ceramic composition which is obtained by forming a mixed calcined powder of a calcined powder of BaTiO₃ and a calcined powder of (BiNa)TiO₃, followed by sintering the mixed calcined powder in an inert gas atmosphere having an oxygen concentration of 1% or less, wherein the composition is represented by a composition formula: [(BiNa)ₓBa₁₋ₓ]TiO₃ in which x satisfies 0 < x ≤ 0.3.

The invention still further proposes, in the above-mentioned structure, a structure in which 3.0 mol% or less of Si oxide, and 4.0 mol% or less of Ca carbonate or Ca oxide are added.

### Advantage of the Invention

According to the method of the invention, there can be provided a semiconductor ceramic composition capable of increasing Curie temperature, and greatly reduced in resistivity at room temperature without using Pb causing environmental pollution.

Since no semiconductive dopants is necessary in the invention, a trivalent rare earth element does not come to be mixed in a Bi (trivalent) site at the time of calcination and sintering, so that a semiconductor ceramic composition capable of easily controlling atomic valence and capable of restraining dispersion of electrical resistance can be provided.

According to the method of the invention, a semiconductor ceramic composition restrained in the volatilization of Bi in the calcining step, suppressed in compositional deviation in Bi-Na and controlled in the formation of different phases containing Na, capable of further reducing resistivity at room temperature, and restrained in fluctuation of Curie temperature can be provided.

According to the method of the invention, since a BaTiO₃ calcined powder and a (BiNa)TiO₃ calcined powder are prepared separately, a single intergranular level is easily formed, and a semiconductor ceramic composition having a good temperature coefficient of resistivity (a jump characteristic) can be provided.

### BEST MODE FOR CARRYING OUT THE INVENTION

The main characteristics of the invention are such that, in a semiconductor ceramic composition, prepared by the method according to claim 1, in which a part ofBa in BaTiO₃ is substituted with Bi-Na, addition of a semiconductive dopant such as a rare earth element, which is essential in conventional compositions, is not necessary, and that a separate calcination method of separately performing a step of preparing a BaTiO₃ calcined powder and a step of preparing a (BiNa)TiO₃ calcined powder is used. The invention will be described in detail below.

As described above, conventionally known materials showing a PTCR characteristic have a problem such that when a trivalent rare earth element is added as semiconductive dopant in the composition containing no Pb in which a part of Ba is substituted with Bi-Na, the rare earth element comes to be mixed in trivalent Bi site at the time of calcination or sintering. According to the invention, as defined by the features of claim 1, even if a semiconductive dopant such as a rare earth element is not added, Ti³⁺ is formed in a solid solution by the reaction of Tⁱ⁴+ + e → Ti³⁺ by performing sintering in an inert gas atmosphere having a low oxygen concentration, whereby a carrier is brought about and a semiconductor can be formed by the formation of the carrier.

In a semiconductor ceramic composition, prepared by the method of claim 1, in which a part of Ba in BaTiO₃ is substituted with Bi-Na, the concept that a semiconductor is formed by the reaction of Ti⁴⁺ + e → Ti³⁺ by performing sintering in an inert gas atmosphere having a low oxygen concentration is entirely new and has never been seen before, and a semiconductor ceramic composition greatly reduced in resistivity at room temperature can be obtained.

Although the advantage of the invention as defined by the features of claim 1 can be obtained only by the above-mentioned novel structure, the advantage is further conspicuous by applying the following separate calcination method of separately performing a step of preparing a BaTiO₃ calcined powder and a step of preparing a (BiNa)TiO₃ calcined powder. Incidentally, the separate calcination method is also truly new idea which has never been seen before.

In the separate calcination method, the step of preparing a BaTiO₃ calcined powder includes mixing BaCO₃ and TiO₂ to prepare a mixed raw material powder, followed by calcining the powder. The calcination temperature is preferably in the range of from 700 to 1,200°C, and the calcination time is preferably 0.5 hours or more, and more preferably from 2 to 6 hours. When the calcination temperature is less than 700°C or the calcination time is less than 0.5 hours, BaTiO₃ is not completely formed, and unreacted BaTiO₃ reacts with the moisture content in the atmosphere and the mixed medium to cause compositional deviation, so that not preferred. On the other hand, when the calcination temperature exceeds 1,200°C, sintered body is generated in the calcined powder, which hinders the solid solubility with a (BiNa)TiO₃ calcined powder mixed later, so that not preferred.

The step of preparing a (BiNa)TiO₃ calcined powder according to the invention includes mixing Na₂CO₃, Bi₂O₃ and TiO₂ as raw material powders to prepare a mixed raw material powder, followed by calcining the powder. The calcination temperature is preferably in the range of from 700 to 950°C, and the calcination time is preferably from 0.5 to 10 hours. When the calcination temperature is less than 700°C or the calcination time is less than 0.5 hours, unreacted NaO reacts with the moisture content in the atmosphere or, in the case of wet mixture, the solvents therein, which causes compositional deviation and dispersion of characteristics, so that not preferred. On the other hand, when the calcination temperature exceeds 950°C or the calcination time is longer than 10 hours, the volatilization of Bi progresses, compositional deviation is caused, and formation of different phases is accelerated, so that not preferred.

Incidentally, with respect to the preferred calcination temperature in the step of preparing the BaTiO₃ calcined powder (from 700 to 1,200°C) and the preferred calcination temperature in the step of preparing the (BiNa)TiO₃ calcined powder (from 700 to 950°C), it is preferred to select optimal temperatures according to use and the like. For example, for performing sufficient reaction while restraining the volatilization of Bi, the calcination temperature of (BiNa)TiO₃ is preferably relatively low by the adjustment of the calcination time and the like. It is preferred to set the calcination temperature of (BiNa)TiO₃ lower than the calcination temperature of BaTiO₃.

By separately carrying out the step of preparing the BaTiO₃ calcined powder and the step of preparing the (BiNa)TiO₃ calcined powder, a semiconductor ceramic composition that is restrained in the volatilization of Bi in (BiNa)TiO₃ in the step of calcination, is controlled in compositional deviation of Bi-Na to thereby suppress the formation of different phases, is further reduced in the resistivity at room temperature, and is restrained in fluctuation of Curie temperature, can be provided.

In the steps of preparing the above-mentioned calcined powders, raw material powders may be crushed in mixing depending upon the grain sizes of the raw material powders. Mixture and crushing may be performed by any of wet mixture and crushing using pure water and ethanol, and dry mixture and crushing, but dry mixture and crushing is preferred for the reason of capable of preventing compositional deviation. Further, BaCO₃, Na₂CO₃ and TiO₂ are exemplified as raw materials in the above, but the advantage of the invention is not impaired even when other Ba compounds and Na compounds are used.

As described above, after separately preparing a BaTiO₃ calcined powder and a (BiNa)TiO₃ calcined powder, the calcined powders are mixed each in a prescribed amount. Mixture may be performed by any of wet mixture using pure water and ethanol, and dry mixture, but dry mixture is preferred for capable of preventing compositional deviation. Depending upon the grain sizes of the calcined powders, crushing may be carried out after mixture, or mixture and crushing may be performed at the same time. The average grain size of the mixed calcined powder after mixture and crushing is preferably from 0.6 to 1.5 µm.

In the above-mentioned step of preparing the BaTiO₃ calcined powder and/or the step of preparing the (BiNa)TiO₃ calcined powder, or in the step of mixing the calcined powders, when 3.0 mol% or less of Si oxide, and 4.0 mol% or less of Ca carbonate or Ca oxide are added, the Si oxide not only restrains extraordinary growth of crystal grains but also easily controls resistivity, and the Ca carbonate or Ca oxide can not only improve sintering property at a low temperature but also control a reducing property, so that preferred. When each of them is added over the limitative amount, the obtained composition does not show semiconducting property, so that not preferred. Addition is preferably performed before the mixture in each step.

A semiconductor ceramic composition prepared according to the invention as defined by the features of claim 1 can be obtained by forming and sintering the mixed calcined powder obtained by the step of mixing the BaTiO₃ calcined powder and the (BiNa)TiO₃ calcined powder.

Forming can be performed with conventionally known forming methods. If necessary, crushed powders may be granulated with a granulator before forming. A compact density after forming is preferably from 2 to 3 g/cm³.

The sintering step is one of primary characteristics of the invention together with the separate calcination method. Sintering is performed in an inert gas atmosphere having an oxygen concentration of 1% or less. The more preferred oxygen concentration is 100 ppm or less. By the above-mentioned condition, Ti³⁺ is formed in a solid solution by the reaction of Ti⁴⁺ + e → Ti³⁺, whereby it becomes possible to bring about a carrier and owing to the formation of the carrier, a semiconductor can be formed without the necessity of semiconductive dopant such as a rare earth element that are essential in conventional compositions. When the oxygen concentration is higher than 1%, the reaction of Ti⁴⁺ + e → Ti³⁺ does not occur, which is not preferred. As the inert gas, nitrogen gas, argon gas, helium gas and carbonic acid gas are preferred.

The sintering temperature is preferably from 1,300 to 1,400°C, and the sintering time is preferably from 2 to 6 hours. When granulation is carried out before the forming, it is preferred to perform binder-eliminating treatment at 300 to 700°C before the sintering. The atmosphere at cooling time after sintering is preferably the above-mentioned atmosphere, but it is not essential.

A semiconductor ceramic composition prepared according to the invention is a semiconductor ceramic composition in which a part of Ba in BaTiO₃ is substituted with Bi-Na, and represented by a composition formula: [(BiNa)ₓBa₁₋ₓ]TiO₃ in which x satisfies 0 < x ≤ 0.3. As described above, the semiconductor ceramic composition can be obtained by separately performing the step of preparing the BaTiO₃ calcined powder and the step of preparing the (BiNa)TiO₃ calcined powder, mixing and forming these calcined powders, and then sintering in an inert gas atmosphere having an oxygen concentration of 1% or less.

In the [(BiNa)ₓBa₁₋ₓ]TiO₃ semiconductor ceramic composition, x in the composition formula represents the component ranges of Bi and Na, and x is in the range of 0 < x ≤ 0.3. Curie temperature cannot be shifted to the high temperature side when x is 0, while when x is higher than 0.3, the composition becomes antiferroelectrics and does not show a jump characteristic. Further, increase in Curie temperature cannot be expected and at the same time resistivity at room temperature undesirably approaches 10⁴ Ω cm, so that it becomes difficult to apply the composition to a PTC heater and the like, so that not preferred.

For the purpose of controlling extraordinary growth of crystal grains, improving a sintering property at low temperature, and contriving the control of a reducing property, 3.0 mol% or less of Si oxide, and 4.0 mol% or less of Ca carbonate or Ca oxide may be added to the [(BiNa)ₓBa₁₋ₓ]TiO₃ semiconductor ceramic composition.

In the [(BiNa)ₓBa₁₋ₓ]TiO₃ semiconductor ceramic composition, it is preferred that the proportion of Bi to Na is 1/1, that is, [(Bi_{0.5}Na_{0.5})ₓBa₁₋ₓ]TiO₃. However, as described in the column of background art, if all the elements constituting the composition are mixed before calcination, Bi volatilizes in the calcining step and compositional deviation occurs in Bi-Na, whereby formation of different phases is accelerated, and accompanied by problems such as the increase in resistivity at room temperature and fluctuation of Curie temperature.

In the invention, by separately calcining BaTiO₃ composition and (BiNa)TiO₃ composition respectively at optimal temperatures, the proportion of Bi to Na can be approached to Bi/Na = 1, so that the resistivity at room temperature can be further lowered as well as the fluctuation in Curie temperature can be restrained.

### EXAMPLE

### EXAMPLE 1

Raw material powders of BaCO₃ and TiO₂ were prepared and blended so as to be BaTiO₃, followed by mixing in pure water. The obtained mixed raw material powder was calcined in the atmosphere at each temperature of 700°C, 900°C and 1,200°C for 4 hours to prepare a BaTiO₃ calcined powder.

Raw material powders of Na₂CO₃, Bi₂O₃ and TiO₂ were prepared and blended so as to be (Bi_{0.5}Na_{0.5})TiO₃, followed by mixing in ethanol. The obtained mixed raw material powder was calcined in the atmosphere at 800°C for 2 hours to prepare a (BiNa)TiO₃ calcined powder.

The BaTiO₃ calcined powder and the (BiNa)TiO₃ calcined powder thus prepared were blended so as to be 73/7 in a molar ratio, followed by mixing and crushing in a pot mill with pure water as a medium until the mixed calcined powder becomes in a size of 0.9 µm, and the mixed calcined powder was then dried. PVA was added to the crushed powder of the mixed calcined powder, followed by mixing, and the mixture was granulated with a granulator. The granulated powder thus obtained was formed with a uniaxial pressing machine, and a binder was eliminated from the compact at 700°C, followed by sintering in an argon gas atmosphere having an oxygen concentration of 1% or less at a sintering temperature of from 1,300 to 1,400°C for 4 hours to obtain a sintered body.

A test piece was obtained by processing the obtained sintered body into a plate having a size of 10 mm × 10 mm × 1 mm, and a temperature change of a resistivity value from room temperature to 270°C of each test piece was measured with a resistivity meter. The measurement results are shown in Table 1. In Table 1, the sample number attached with * means a comparative example. The temperature coefficient of resistivity was obtained by the following expression: α = (lnR₁ - lnR_{c}) × 100/(T₁ - T_{c}), wherein R_{c} is a maximum resistivity, R_{c} is a resistivity in T_{c}, T₁ is a temperature indicating R₁, and T_{c} is the Curie temperature.

In Table 1, the BaTiO₃ calcined powder and the (BiNa)TiO₃ calcined powder in Sample Nos. 16 to 18 were not prepared separately but the starting raw materials of all the constituent elements were mixed and calcined in the atmospheric air at 1,000°C for 4 hours, followed by crushing and sintering in the same manner as in Example 1. Sample No. 19 was obtained by adding 1.4 mol% of CaCO₃ in the step of mixing the calcined powders, Sample No. 20 was obtained by adding 0.4 mol% of SiO₂ in the step of mixing the calcined powders, and Sample No. 21 was obtained by adding 1.4 mol% of CaCO₃ and 0.4 mol% of SiO₂ in the step of mixing the calcined powders. Sample Nos. 25 and 26 are examples in which sintering was performed in an argon gas atmosphere having an oxygen concentration of 1.8%, and Sample Nos. 27 and 28 are examples in which sintering was performed in an atmospheric air.

As can be clearly seen from the results in Table 1, the semiconductor ceramic compositions prepared according to the invention, in which the separate calcination method of separately performing the step of preparing the BaTiO₃ calcined powder and the step of preparing the (BiNa)TiO₃ calcined powder was employed and the sintering step was performed in an argon gas atmosphere having an oxygen concentration of 1% or less, were free from fluctuation in Curie temperature, were almost free from dispersion in electrical resistance, were restrained in the increase in resistivity at room temperature, and were possessed of a high jump characteristic.

On the other hand, Comparative Sample Nos. 16 to 18 obtained by mixing the starting raw materials of all the constituent elements before calcination, followed by sintering, were high in resistivity at room temperature and low in a jump characteristic. This is presumably due to the fact that Bi became a liquid phase at the calcining stage and formed a complicated intergranular structure, so that a single intergranular level was difficult to be formed, and a jump characteristic was lowered.

**TABLE 1**

| Sample No. | Calcination Temperature of BaTiO₃ (°C) | Sintering Temperature (°C) | ρ25 (Ω cm) | Tc (°C) | Temperature Coefficient of Resistance (%/°C) |
|---|---|---|---|---|---|
| 1 | 700 | 1,300 | 70.2 | 167.7 | 20.6 |
| 2 | 900 | | 81.1 | 176.3 | 21.7 |
| 3 | 1,200 | | 73.4 | 173.1 | 19.2 |
| 4 | 700 | 1,320 | 53.1 | 163.4 | 16.7 |
| 5 | 900 | | 85.5 | 177.9 | 23.8 |
| 6 | 1,200 | | 52.7 | 167.9 | 17.1 |
| 7 | 700 | 1,340 | 85.3 | 163.5 | 17.9 |
| 8 | 900 | | 91.1 | 177.6 | 24.3 |
| 9 | 1,200 | | 66.8 | 169.1 | 20.8 |
| 10 | 700 | 1,360 | 68.9 | 167.8 | 19.9 |
| 11 | 900 | | 65.2 | 173.0 | 22.9 |
| 12 | 1,200 | | 70.3 | 163.1 | 21.2 |
| 13 | 700 | 1,380 | 83.8 | 167.9 | 18.7 |
| 14 | 900 | | 94.4 | 167.8 | 19.6 |
| 15 | 1,200 | | 58.1 | 172.7 | 21.3 |
| 16* | 700 | 1,320 | 143.8 | 172.7 | 12.9 |
| 17* | 900 | | 105.7 | 163.3 | 11.8 |
| 18* | 1,200 | | 152.2 | 163.2 | 9.3 |
| 19 | 900 | | 80.2 | 169.2 | 16.9 |
| 20 | 900 | | 77.8 | 165.5 | 16.6 |
| 21 | 900 | | 73.2 | 162.8 | 16.6 |
| 22 | 900 | 1,290 | 45.5 | 172.7 | 4.2 |
| 23 | 900 | 1,400 | 76.7 | 160.2 | 17.8 |
| 24 | 1,200 | | 38.7 | 173.5 | 12.4 |
| 25* | 900 | 1,320 | 238.1 | 147.6 | 21.1 |
| 26* | 1,200 | | 167.4 | 150.1 | 18.2 |
| 27* | 900 | | Measurement impossible. | | |
| 28* | 1,200 | | Measurement impossible. | | |

While the invention has been described in detail and with reference to specific examples thereof, it will be apparent to one skilled in the art that various changes and modifications can be made therein without departing from the scope thereof, which is defined by the appended claims.

The present application is related to Japanese patent application filed on October 27, 2006 (Japanese Patent Application No. 2006-292471).

### INDUSTRIAL APPLICABILITY

The semiconductor ceramic composition prepared according to the invention is optimal as a material for a PTC thermistor, a PTC heater, a PTC switch, a temperature detector, and the like.

## Claims

1. A method for producing a semiconductor ceramic composition in which a part of Ba in BaTiO₃ is substituted with Bi-Na, wherein the semiconductor ceramic composition is represented by a composition formula [(BiNa)ₓBa₁₋ₓ]TiO₃ in which x satisfies 0 < x ≤ 0.3, the method comprising the step of preparing a calcined powder of BaTiO₃, a step of preparing a calcined powder of (BiNa)TiO₃, a step of mixing the calcined powder of BaTiO₃ and the calcined powder of (BiNa)TiO₃, and a step of forming and sintering said mixed calcined powder, wherein the sintering step is carried out in an inert gas atmosphere having an oxygen concentration of 1 % or less.

2. The method for producing a semiconductor ceramic composition as claimed in claim 1, wherein the calcining temperature in the step of preparing the calcined powder of BaTiO₃ is from 700 to 1,200°C.

3. The method for producing a semiconductor ceramic composition as claimed in claim 1, wherein the calcining temperature in the step of preparing the calcined powder of (BiNa)TiO₃ is from 700 to 950°C.

4. The method for producing a semiconductor ceramic composition as claimed in claim 1, wherein in the step of preparing the calcined powder of BaTiO₃, in the step of preparing the calcined powder of (BiNa)TiO₃ or in both of the steps, 3.0 mol% or less of Si oxide, and 4.0 mol% or less of Ca Carbonate or Ca oxide are added before the calcination.

5. The method for producing a semiconductor ceramic composition as claimed in claim 1, wherein in the step of mixing the calcined powder of BaTiO₃ and the calcined powder of (BiNa)TiO₃, 3.0 mol% or less of Si oxide, and 4.0 mol% or less of Ca carbonate or Ca oxide are added.

## Patentansprüche

1. Verfahren zur Herstellung einer keramischen Halbleiterzusammensetzung, bei welcher ein Teil des Ba in BaTiO₃ durch Bi-Na ersetzt ist, wobei die keramische Halbleiterzusammensetzung durch eine Zusammensetzungsformel [(BiNa)ₓBa₁₋ₓ]TiO₃ dargestellt wird, in welcher x 0 < x ≤ 0,3 entspricht, wobei das Verfahren den Schritt der Herstellung eines calcinierten BaTiO₃ Pulvers, einen Schritt der Herstellung eines calcinierten (BiNa)TiO₃ Pulvers, einen Schritt des Mischens des calcinierten BaTiO₃ Pulvers und des calcinierten (BiNa)TiO₃ Pulvers, und einen Schritt des Formens und des Sinterns des gemischten calcinierten Pulvers umfasst, wobei der Sinterschritt in einer Inertgasatmosphäre mit einer Sauerstoffkonzentration von 1 % oder weniger durchgeführt wird.

2. Verfahren zur Herstellung einer keramischen Halbleiterzusammensetzung wie in Anspruch 1 beansprucht, wobei die Calcinierungstemperatur bei dem Schritt der Herstellung des calcinierten BaTiO₃ Pulvers von 700 bis 1200°C beträgt.

3. Verfahren zur Herstellung einer keramischen Halbleiterzusammensetzung wie in Anspruch 1 beansprucht, wobei die Calcinierungstemperatur bei dem Schritt der Herstellung des calcinierten (BiNa)TiO₃ Pulvers von 700 bis 950°C beträgt.

4. Verfahren zur Herstellung einer keramischen Halbleiterzusammensetzung wie in Anspruch 1 beansprucht, wobei bei dem Schritt der Herstellung des calcinierten BaTiO₃ Pulvers, bei dem Schritt der Herstellung des calcinierten (BiNa)TiO₃ Pulvers oder bei beiden Schritten vor dem Calcinieren 3,0 mol-% oder weniger Si-Oxid und 4,0 mol-% oder weniger Ca-Carbonat oder Ca-Oxid zugefügt werden.

5. Verfahren zur Herstellung einer keramischen Halbleiterzusammensetzung wie in Anspruch 1 beansprucht, wobei bei dem Schritt des Mischens des calcinierten BaTiO₃ Pulvers und des calcinierten (BiNa)TiO₃ Pulvers 3,0 mol-% oder weniger Si-Oxid und 4,0 mol-% oder weniger Ca-Carbonat oder Ca-Oxid zugefügt werden.

## Revendications

1. Procédé de production d'une composition de céramique semi-conductrice dans laquelle une partie de Ba dans BaTiO₃ est substituée par Bi-Na, dans lequel la composition de céramique semi-conductrice est représentée par une formule de composition [(BiNa)ₓBa₁₋ₓ]TiO₃ dans laquelle x satisfait 0 < x ≤ 0,3, le procédé comprenant l'étape de préparation d'une poudre calcinée de BaTiO₃, une étape de préparation d'une poudre calcinée de (BiNa)TiO₃, une étape de mélange de la poudre calcinée de BaTiO₃ et de la poudre calcinée de (BiNa)TiO₃ et une étape de formation et de frittage de ladite poudre calcinée mélangée, l'étape de frittage étant réalisée dans une atmosphère de gaz inerte ayant une concentration en oxygène inférieure ou égale à 1 %.

2. Procédé de production d'une composition de céramique semi-conductrice selon la revendication 1, dans lequel la température de calcination dans l'étape de préparation de la poudre calcinée de BaTiO₃ est de 700 à 1200 °C.

3. Procédé de production d'une composition de céramique semi-conductrice selon la revendication 1, dans lequel la température de calcination dans l'étape de préparation de la poudre calcinée de (BiNa)TiO₃ est de 700 à 950 °C.

4. Procédé de production d'une composition de céramique semi-conductrice selon la revendication 1, dans lequel dans l'étape de préparation de la poudre calcinée de BaTiO₃, dans l'étape de préparation de la poudre calcinée de (BiNa)TiO₃ ou dans les deux étapes, 3,0 % en moles ou moins d'oxyde de Si et 4,0 % en moles ou moins de carbonate de Ca ou d'oxyde de Ca sont ajoutés avant la calcination.

5. Procédé de production d'une composition de céramique semi-conductrice selon la revendication 1, dans lequel dans l'étape de mélange de la poudre calcinée de BaTiO₃, et de la poudre calcinée de (BiNa)TiO₃, 3,0 % en moles ou moins d'oxyde de Si et 4,0 % en moles ou moins de carbonate de Ca ou d'oxyde de Ca sont ajoutés.
